Europäisches Patentamt

(19) European Patent Office

Office européen des brevets

(11) Numéro de publication: **0 069 606**
**B1**

(12) # FASCICULE DE BREVET EUROPEEN

(45) Date de publication du fascicule du brevet:
12.09.84

(51) Int. Cl.³: **H 01 L 29/80**, H 01 L 29/08,
H 01 L 21/306, H 01 L 29/04

(21) Numéro de dépôt: 82401016.9

(22) Date de dépôt: 04.06.82

(54) **Transistor à effet de champ vertical à jonction et procédé de fabrication.**

(30) Priorité: **16.06.81 FR 8111838**

(43) Date de publication de la demande:
**12.01.83 Bulletin 83/2**

(45) Mention de la délivrance du brevet:
**12.09.84 Bulletin 84/37**

(84) Etats contractants désignés:
**DE FR GB IT NL**

(56) Documents cités:
**US - A - 4 262 296**

**IEEE TRANSACTIONS ON ELECTRON DEVICES; VOL: ED-25, no. 3, mars 1978, New York (US) J.I. NISHIZAWA et al.: "High-frequency high-power static induction transistor", pages 314-322
IEEE INTERNATIONAL ELECTRON DEVICES MEETING, Technical Digest, 4-6 décembre 1978, Washington, New York (US) J. NISHIZAWA et al.: "Bipolar mode static induction transistor (BSIT.)High speed switching device", pages 676-679
IEEE TRANSACTIONS ON ELECTRON DEVICES, vol. ED-25, no. 1, janvier 1978, New York (US) O. OZAWA et al.: "A vertical FET with self-aligned ion-implanted source and gate regions", pages 56-57
IEEE TRANSACTIONS ON ELECTRON DEVICES, vol.**

(73) Titulaire: **THOMSON-CSF, 173, Boulevard Haussmann, F-75379 Paris Cedex 08 (FR)**

(72) Inventeur: **Briere, Pierre, THOMSON-CSF SCPI 173, bld Haussmann, F-75379 Paris Cedex 08 (FR)**

(74) Mandataire: **de Beaumont, Michel et al, THOMSON-CSF SCPI 173, Bld Haussmann, F-75379 Paris Cedex 08 (FR)**

(56) Documents cités: (suite)
**ED-26, no. 4, avril 1979, New York (US) T. SAKAI et al.: "Elevated electrode integrated circuits", pages 379-385
SOLID STATE ELECTRONICS, vol. 21, no. 9, septembre 1978, Pergamon Press Ltd., (GB) B.A. BOXALL: "A technique for producing polysilicon patterns with bvelled edge profiles using wet etching", pages 1173-1174
IEEE TRANSACTIONS ON ELECTRON DEVICES, vol. ED-28, no. 7, juillet 1982, New York (US) T. TAMAMA et al.: "Bipolar-mode. Transistors on a voltage-controlled scheme", pages 777-783**

# Description

La présente invention concerne une structure de transistor à effet de champ vertical à jonction dans laquelle les électrodes de source et de grille sont disposées sous forme de doigts parallèles alternés de très petites largeurs sur un substrat semi-conducteur et un procédé de fabrication permettant une miniaturisation importante d'une telle structure.

Les premiers transistors à effet de champ à jonction verticaux ont, à la connaissance de la demanderesse, été décrits dans le brevet français N° 1163241 déposé le 10 décembre 1956 par Stanislas Teszner. La fig. 6 de ce brevet est reprise sous une forme légèrement modifiée dans la fig. 1 ci-jointe. On y voit un transistor à effet de champ vertical comprenant un substrat de silicium 1 de type N dans lequel, à partir d'une surface, sont formées des zones diffusées 2 de type P relativement profondes. Une électrode 3 de drain D est solidaire de la face inférieure; des électrodes 4 de source 5 sont solidaires de la partie du substrat N apparaissant sur la face supérieure; et des électrodes de commande ou de grille sont solidaires de la partie apparente des zones de type P sur la surface supérieure. Des zones de type N⁺ non référencées assurent l'ohmicité du contact avec les électrodes de source et de drain. En l'absence de tension appliquée sur les électrodes de grille, un courant peut passer entre les électrodes de source et de drain si une différence de potentiel est appliquée. Si une tension de polarité convenable est appliquée aux électrodes de grille, une charge d'espace se développe autour des zones de type P et ferme les canaux permettant le passage d'un courant de la source au drain. Depuis cette première description d'un transistor à effet de champ vertical, de nombreuses structures ont été décrites pour permettre la miniaturisation des transistors à effet de champ verticaux.

Un objet de la présente invention est de prévoir une nouvelle structure particulièrement miniaturisée et un procédé de fabrication d'une telle structure permettant d'utiliser un seul masquage et d'obtenir ainsi des pas élémentaires de dimensions pouvant être inférieures à 5 microns (par exemple, 3 à 4 microns).

Un autre objet de l'invention est de permettre la réalisation d'un transistor à effet de champ vertical à très faible longueur de canal.

Pour atteindre ces objets ainsi que d'autres, la présente invention prévoit une structure de transistor à effet de champ vertical à jonction dans laquelle des électrodes de source et de grille sont disposées sous forme de doigts parallèles alternés de très petite largeur sur un substrat semi-conducteur, des bandes fortement dopées de même type de conductivité que le substrat étant formées à la surface du substrat, chaque électrode de grille étant constituée d'une bande de métallisation reposant sur une région allongée pénétrant dans le substrat et de type de conductivité différent de celui du substrat, les métallisations de source reposant sur un rail de silicium polycristallin de même type de conductivité que le substrat, formé sur les bandes fortement dopées, et ayant une section du type de celle d'un diabolo (le sens de cette expression sera exposé ci-après en relation avec les figures).

Pour fabriquer un tel transistor, la présente invention prévoit les étapes suivantes: former sur un substrat de silicium monocristallin une couche de silicium polycristallin du type de conductivité du substrat dont la partie médiane est fortement dopée et dont les parties inférieure et supérieure sont faiblement dopées; former une couche de masquage en forme de bandes sur la surface de silicium polycristallin et procéder à une attaque du silicium polycristallin en utilisant un moyen attaquant plus vite des parties fortement dopées, d'où il résulte que l'on obtient des rails de silicium polycristallin entre lesquels affleure la surface du substrat, ces rails ayant une section du type de celle d'un diabolo; procéder à un traitement thermique oxydant ou à un dépôt diélectrique en phase vapeur; implanter un dopant de type opposé à celui du substrat perpendiculairement à la surface principale de celui-ci; éliminer la couche d'oxyde implanté et la couche ayant servi à masquer des bandes de silicium polycristallin; procéder à un recuit durant lequel le dopant contenu dans les rails de silicium polycristallin diffuse dans le substrat pour former des zones superficielles fortement dopées; et pulvériser une substance conductrice perpendiculairement à la surface principale du substrat.

Un article de Tetsushi Sakai *et al.* paru dans IEEE Transactions on Electron Devices, vol. ED-26, N° 4, avril 1979, pp. 379-384, décrit l'utilisation de rails de silicium polycristallin de forme distincte pour réaliser des contacts auto-alignés sur des transistors bipolaires.

Parmi les applications d'un dispositif tel que celui de la présente invention, on peut principalement retenir les applications dans le domaine de très hautes fréquences, allant du mégahertz à plusieurs gigahertz.

Ces objets, caractéristiques et avantages ainsi que d'autres de la présente invention seront exposés plus en détail dans la description suivante de modes de réalisation particuliers faite en relation avec les figures jointes parmi lesquelles:

la fig. 1 représente un transistor à effet de champ vertical selon l'art antérieur,

la fig. 2 représente un transistor à effet de champ vertical selon la présente invention,

les fig. 3 à 7 représentent des étapes successives de fabrication d'un transistor à effet de champ selon la présente invention, les fig. 6A et 6B représentant deux variantes possibles.

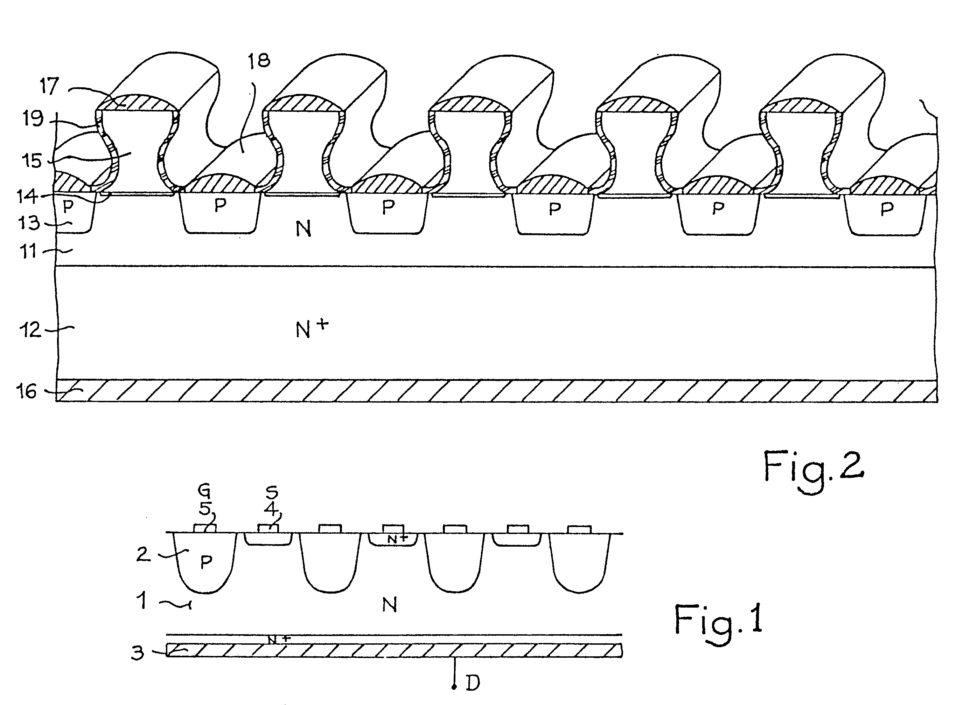

Comme le représente la fig. 2, un transistor à effet de champ vertical selon la présente invention comprend une couche faiblement dopée 11, par exemple de type N, sur une couche de même type plus fortement dopée 12, la couche N étant par exemple formée par épitaxie sur un substrat N⁺. A partir de la surface supérieure de cette couche N sont formées des bandes 13 dopées selon le type de conductivité P et des bandes 14 dopées selon le type de conductivité N⁺ et de profondeur de diffusion nettement plus faible que celle des bandes 13. Les bandes 14 sont surmontées de rails 15 de silicium polycristallin ayant sensiblement la forme représentée dans la figure et se caractérisant essentiellement par le fait que leurs largeurs supérieure et inférieure sont plus fortes que leurs largeurs médianes. Ci-après, on dira pour désigner des rails ayant une telle forme qu'ils ont une section du type de celle d'un diabolo. Une métallisation du drain 16 est solidaire de la face N⁺ inférieure, une métallisation de source 17 est solidaire de la face supérieure des rails 15, et une métallisation 18 est solidaire de la surface des bandes de type P 13. Les faces latérales des rails 15 sont revêtues d'une couche isolante 19, de la silice dans le mode de réalisation particulier décrit ici. Comme on le verra dans la description détaillée du procédé décrit ci-après, un avantage de cette structure est qu'elle peut être fabriquée par des techniques d'auto-alignement successives, ce qui supprime tout problème de repositionnement de masque.

La couche N⁺ 14 de très faible profondeur de diffusion sert à assurer un bon contact ohmique entre le rail de silicium polycristallin 15 et la couche 11 de type N pour assurer une conductivité satisfaisante vers la métallisation de source 17.

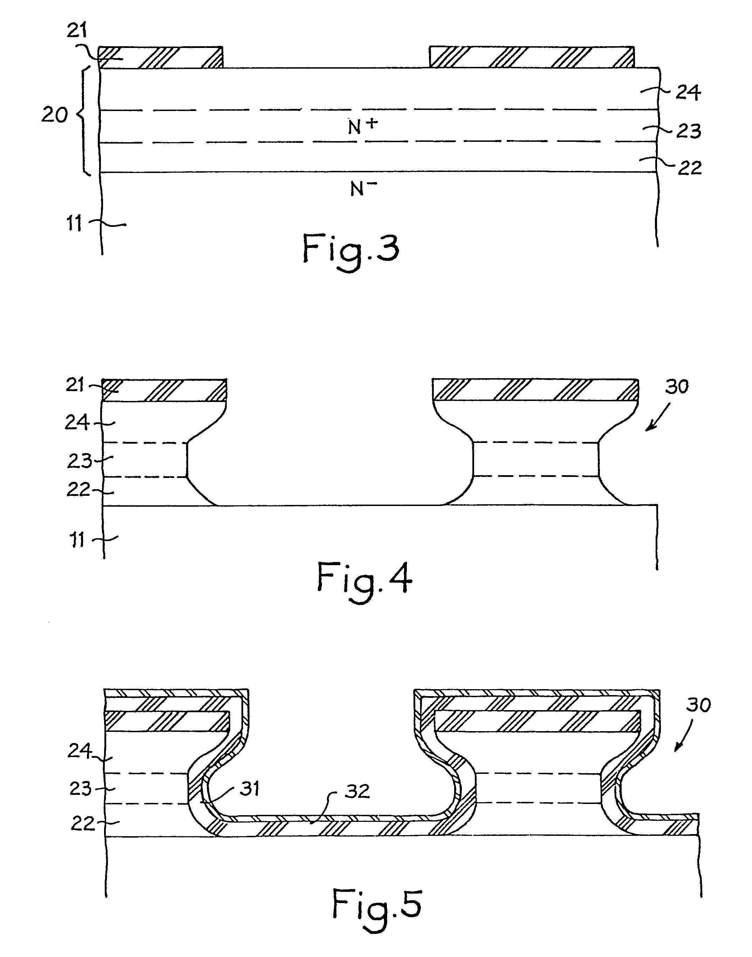

Les fig. 3 à 7 exposent certaines des étapes successives de fabrication d'un dispositif selon l'invention. Dans une première étape, à partir de la couche supérieure 11 de type N, indiquée N⁻ pour souligner que son niveau de dopage est faible, est formée une couche de silicium polycristallin 20 sur laquelle est formée une couche de masquage 21 en forme de bandes rapprochées, par exemple une couche de silice ou une couche de nitrure de silicium. La couche de silicium polycristallin 20 se décompose en trois sous-couches à niveaux de dopage différents. La partie inférieure 22 et la partie supérieure 24 sont faiblement dopées ou non dopées et la partie médiane 23 est fortement dopée. On procède ensuite à une attaque chimique par un produit sélectif attaquant plus vite le silicium polycristallin fortement dopé que le silicium polycristallin faiblement dopé.

On obtient ainsi, comme l'illustre la fig. 4, des rails parallèles de silicium polycristallin 30 qui ont une section du type de celle d'un diabolo, plus étroite aux emplacements correspondant à la couche initiale 23 fortement dopée.

Après cela, comme l'illustre la fig. 5, on procède à une légère oxydation thermique ou à un dépôt de silice en phase vapeur puis à un dépôt de nitrure de silicium en phase vapeur. Cette double couche de protection est désignée par la référence 31 sur les parois des rails 30 et par la référence 32 aux emplacements où la surface du silicium monocristallin 11 apparaît.

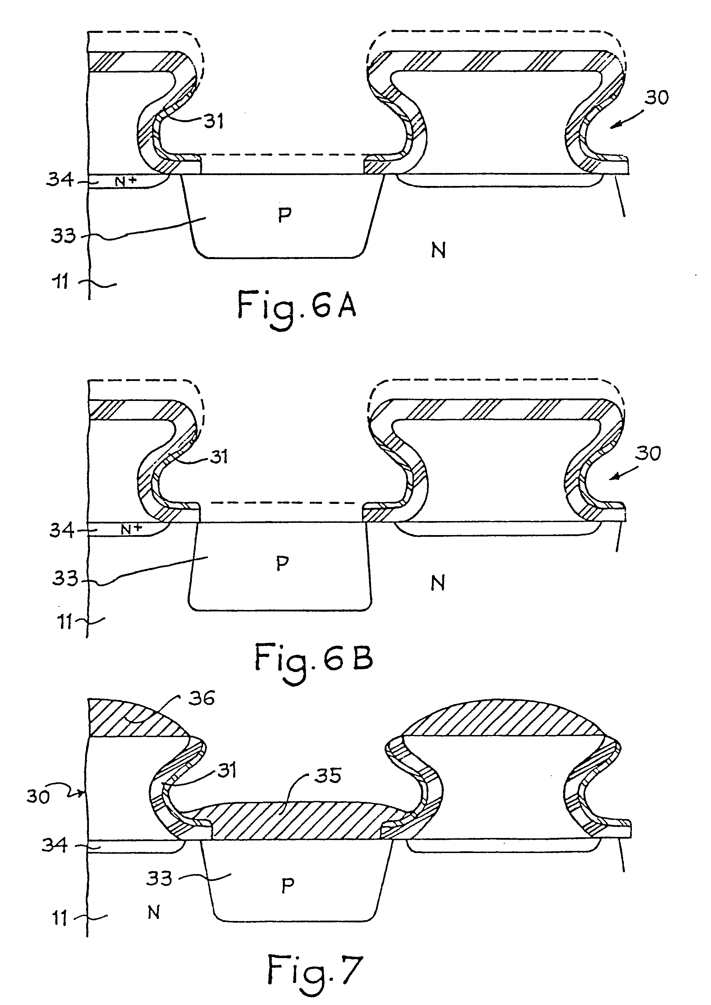

Dans l'étape suivante, illustrée en fig. 6A ou 6B, il est procédé à un enlèvement de la double couche 32 et à un dopage de type P de la surface supérieure de la couche de silicium monocristallin 11 aux emplacements non revêtus de silicium polycristallin, l'ordre de ces étapes pouvant différer selon les technologies choisies. Par exemple, on pourra d'abord procéder à une implantation ionique qui traverse la double couche 32 et qui est délimitée par les bords supérieurs en saillie des rails 30. On éliminera ensuite par attaque chimique cette double couche 32, d'une part en jouant sur la sélectivité d'attaque entre la double couche 32 ayant suivi une implantation de type P et la double couche 31 n'ayant pas subi d'implantation étant donné son caractère latéral et en retrait, d'autre part, par rapport à la couche revêtant la surface supérieure des rails 30 en jouant sur les différences d'épaisseur. On pourra également enlever au moins partiellement la double couche 32 avant d'effectuer une diffusion ou une implantation de type P, en effectuant par exemple une implantation verticale d'un dopant propre à rendre cette double couche 32 sélectivement attaquable par rapport à la double couche latérale 31 et en procédant ensuite seulement à la diffusion ou à l'implantation d'un dopant de type P.

La fig. 6B illustre un détail de la présente invention selon lequel il est souhaitable de procéder à une implantation très profonde du dopant de type P, puis ensuite seulement à une étape de recuit thermique pour que la zone implantée de type P ait, en coupe, l'allure illustrée, c'est-à-dire que son extension latérale au niveau de la surface de la couche de silicium monocristallin 11 est relativement faible. Pour accroître encore cet effet, on aurait pu, lors de l'étape de gravure du silicium polycristallin illustrée en fig. 4, poursuivre l'attaque pour éliminer une portion superficielle du substrat de silicium monocristallin, par exemple sur une profondeur de 1000 à 2000 angströms.

En même temps que l'on recuit l'implantation pour fournir les zones 33 de type P, il se produit une diffusion du dopant contenu dans le silicium polycristallin des rails 30. Ainsi, les trois zones 22, 23 et 24 disparaissent pour former une zone unique fortement dopée. Du fait que la zone fortement dopée 23 est séparée du substrat 11 par une couche faiblement dopée 22, le dopant N⁺ diffuse beaucoup moins dans le silicium monocristallin que le dopant P. Ainsi, les zones de surdopage N⁺ 34 sont moins profondes que les zones de type P 33. On choisira également, de préférence, les produits dopants justement pour accroître cette différence de profondeur.

Dans une dernière étape, dont le résultat est illustré en fig. 7, on supprime la couche 21 protégeant la surface supérieure des rails, puis on procède à un dépôt de métallisation, de préférence par vaporisation ou pulvérisation à partir d'une source ponctuelle pour obtenir des bandes de métallisation de grille 35 et des bandes de métallisation de source 36 à des niveaux différents. Cet alignement automatique est obtenu grâce à la forme particulière des rails 30 qui interdisent toute continuité entre les métallisations 35 et 36.

La forme de la section des rails 30 résulte des niveaux de dopage des sous-couches 22, 23 et 24 formant la couche de silicium polycristallin 20. Cette couche de silicium polycristallin peut être formée de diverses façons: ou bien par dépôt d'une couche de silicium polycristallin non dopé dans laquelle est implanté un dopant N⁺ à une profondeur choisie, ou bien par dépôt successif d'une couche non dopée, d'une couche dopée *in situ*, puis d'une couche superficielle non dopée.

La diffusion N⁺ 34 a été représentée comme ayant une certaine épaisseur. En fait, les atomes dopants N⁺ devront pénétrer le moins possible dans la couche de silicium monocristallin 11 pour éviter que la diffusion N⁺ 34 ne rejoigne latéralement la diffusion P 33.

A titre d'exemple pratique, une structure selon la présente invention peut être réalisée avec un pas de 4 microns en choisissant une épaisseur totale de la couche de silicium polycristallin 20 de l'ordre de 5000 angströms, et, pour la double couche 31, une épaisseur de silice de l'ordre de 1000 angströms et une épaisseur de nitrure de l'ordre de 500 angströms. Le dopant de type N⁺ sera de préférence l'arsenic qui présente une vitesse de diffusion relativement lente et le dopant de type P pourra être du bore dans le cas où l'on réalise une diffusion ou bien du bore ou du gallium dans le cas où la couche P est obtenue par implantation, la profondeur de jonction de la couche de type P 33 étant alors de l'ordre de 3000 à 10 000 angströms et la profondeur de la couche 34 de l'ordre de quelques centaines d'angströms.

La présente invention est également réalisable avec des substrats semi-conducteurs autres que le silicium ou des types de conductivité opposés à ceux qui ont été explicitement décrits.

## Revendications

1. Structure de transistor à effet de champ vertical à jonction dans laquelle les électrodes de source et de grille sont disposées sous forme de doigts parallèles alternés de très petite largeur sur un substrat semi-conducteur, des bandes fortement dopées de même type de conductivité que le substrat étant formées à la surface du substrat, chaque électrode de grille étant constituée d'une bande de métallisation reposant sur une région allongée pénétrant dans le substrat et de type de conductivité distinct de celui du substrat, caractérisée en ce que les métallisations de source (17) reposent sur un rail de silicium polycristallin (15) de même type de conductivité que le substrat, formé sur les bandes fortement dopées (14) et ayant une section du type de celle d'un diabolo.

2. Procédé de fabrication d'un transistor à effet de champ vertical à jonction selon la revendication 1, caractérisé en ce qu'il comprend les étapes suivantes:
— former sur un substrat de silicium monocristallin une couche de silicium polycristallin (20) du type de conductivité du substrat dont la partie médiane (23) est fortement dopée et dont les parties inférieure (22) et supérieure (24) sont faiblement dopées,
— former une couche de masquage (21) en forme de bandes sur la surface de silicium polycristallin,

— procéder à une attaque du silicium polycristallin par un produit attaquant plus vite les parties fortement dopées d'où il résulte que l'on obtient des rails (30) de silicium polycristallin entre lesquels affleure la surface du substrat, ces rails ayant une section du type de celle d'un diabolo,
— former une couche de protection,
— implanter un dopant de type opposé à celui du substrat perpendiculairement à la surface principale de celui-ci,
— éliminer la portion (32) de la couche de protection ayant subi l'implantation et la couche (21) ayant servi à masquer des bandes de silicium polycristallin,
— procéder à un recuit durant lequel le dopant contenu dans les rails (30) de silicium polycristallin diffuse dans le substrat pour former des zones superficielles fortement dopées (34),
— pulvériser une substance conductrice (35, 36) perpendiculairement à la surface principale du substrat.

3. Procédé selon la revendication 2, caractérisé en ce que la couche de protection est une double couche constituée d'une couche de silice d'une épaisseur de l'ordre de 1000 angströms et d'une couche de nitrure de silicium d'une épaisseur de l'ordre de 500 angströms.

4. Procédé selon la revendication 2, caractérisé en ce que la couche de silicium polycristallin a une épaisseur de l'ordre de 4000 à 8000 angströms et la couche résultant du traitement thermique oxydant une épaisseur de l'ordre du millier d'angströms.

5. Procédé selon la revendication 2, caractérisé en ce que le substrat est de type N, le produit dopant le silicium polycristallin de l'arsenic, et le produit dopant assurant le dopage des zones de grille du bore ou du gallium.

## Patentansprüche

1. Vertikal-Feldeffekt-Transistorstruktur mit Halbleiterübergang, worin die Source- und Gate-Elektroden in Form von abwechselnden parallelen Fingern sehr geringer Breite auf einem Halbleitersubstrat aufgebracht sind, während hochdotierte Streifen desselben Leitungstyps wie das Substrat an der Oberfläche des Substrates gebildet sind, wobei jede Gate-Elektrode aus einem Metallisierungsstreifen gebildet ist, der auf einem gestreckten Bereich ruht, der in das Substrat eindringt und einen vom Substrat verschiedenen Leitungstyp aufweist, dadurch gekennzeichnet, dass die Source-Metallisierungen (17) auf einem schienenförmigen Körper aus polykristallinem Silicium (15) desselben Leitungstyps wie das Substrat ruhen, welcher auf den hochdotierten Streifen (14) gebildet ist und einen Querschnitt von der Art eines Diabolos aufweist.

2. Verfahren zur Herstellung eines Vertikal-Feldeffekt-Transistors mit Halbleiterübergang nach Anspruch 1, dadurch gekennzeichnet, dass es die folgenden Schritte umfasst:

— Bildung einer polykristallinen Siliciumschicht (20) auf einem monokristallinen Siliciumsubstrat mit demselben Leitungstyp wie das Substrat, dessen Mittelteil (23) hochdotiert ist und dessen unterer (22) und oberer (24) Teil schwachdotiert sind,

— Bildung einer streifenförmigen Maskierungsschicht (21) auf der Oberfläche des polykristallinen Siliciums,

— Vornahme einer Ätzung des polykristallinen Siliciums durch ein Mittel, welches die hochdotierten Teile schneller angreift, wodurch sich ergibt, dass schienenförmige Körper (30) aus polykristallinem Silicium gebildet werden, zwischen denen die Oberfläche des Substrats anschliesst, wobei diese schienenförmigen Körper einen Querschnitt von der Art eines Diabolos aufweisen,

— Bildung einer Schutzschicht,

— Implantation eines Dotierungsmittels von entgegengesetztem Typ wie das Substrat, senkrecht zur Hauptoberfläche desselben,

— Beseitigung desjenigen Teiles (32) der Schutzschicht, der die Implantation erhalten hat und der Schicht (21), die zur Abdeckung der Streifen aus polykristallinem Silicium gedient hat,

— Vornahme einer thermischen Nachbehandlung, während welcher das in den schienenförmigen Körpern (30) aus polykristallinem Silicium enthaltene Dotiermittel in das Substrat hineindiffundiert, um hochdotierte Oberflächenzonen (34) zu bilden,

— Zerstäuben einer leitfähigen Substanz (35, 36) senkrecht zu der Hauptoberfläche des Substrats.

3. Verfahren nach Anspruch 2, dadurch gekennzeichnet, dass die Schutzschicht eine doppelte Schicht ist, welche aus einer Siliciumoxidschicht von einer Dicke in der Grössenordnung von 1000 Ångström und einer Siliciumnitridschicht einer Dicke in der Grössenordnung von 500 Ångström gebildet ist.

4. Verfahren nach Anspruch 2, dadurch gekennzeichnet, dass die polykristalline Siliciumschicht eine Dicke in der Grössenordnung von 4000 bis 8000 Ångström aufweist und die aus einer oxidierenden thermischen Behandlung resultierende Schicht eine Dicke in der Grössenordnung von 1000 Ångström aufweist.

5. Verfahren nach Anspruch 2, dadurch gekennzeichnet, dass das Substrat vom N-Typ, das Dotierungsmittel für das polykristalline Silicium Arsen und das für die Dotierung der Gate-Zonen verwendete Dotierungsmittel Bor oder Gallium ist.

## Claims

1. Vertical field-effect junction transistor structure in which the source and gate electrodes are disposed in the form of alternate parallel fingers of very small width on a semiconductor substrate, highly doped strips of the same conductivity type as the substrate being formed at the surface of the substrate, each gate electrode being formed by a metallization strip resting on an elongated region penetrating into the substrate and of conductivity type different to that of the substrate, characterized in that the source metallizations (17) rest on a rail of polycristalline silicon (15) of the same conductivity type as the substrate formed on the highly doped strips (14) and having a cross-section of the type of a diabolo.

2. Method of fabricating a vertical field-effect junction transistor according to claim 1, characterized in that it comprises the following steps:

— formation on a substrate of monocrystalline silicon of a polycrystalline silicon layer (20) of the conductivity type of the substrate of which the middle portion (23) is highly doped and of which the lower (22) and upper (24) parts are weakly doped,

— formation of a strip-shape masking layer (21) on the surface of the polycrystalline silicon,

— execution of an etching of the polycrystalline silicon by an agent attacking the highly doped parts more rapidly, as a result of which rails (30) of polycrystalline silicon are obtained joined by the intervening substrate surface, said rails having a cross-section of the type of a diabolo,

— formation of a protection layer,

— implantation of a doping agent of type opposite to that of the substrate perpendicularly to the major surface of the latter,

— elimination of the portion (32) of the protection layer subjected to the implantation and the layer (21) which served to mask the polycrystalline silicon strips,

— execution of a subsequent thermal treatment during which the doping agent contained in the rails (30) of polycrystalline silicon diffuses into the substrate to form highly doped surface zones (34),

— sputtering of a conductive substance (35, 36) perpendicularly to the major surface of the substrate.

3. Method according to claim 2, characterized in that the protection layer is a double layer formed by a silicon oxide layer of a thickness of the order of 1000 Angströms and a silicon nitride layer of a thickness of the order of 5000 Angströms.

4. Method according to claim 2, characterized in that the polycrystalline silicon layer has a thickness of the order of 4000 to 8000 Angströms and the layer resulting from the oxidizing thermal treatment has a thickness of the order of 1000 Angströms.

5. Method according to claim 2, characterized in that the substrate is of the N type, the doping agent for the polycrystalline silicon is arsenic and the doping agent effecting the doping of the gate zones is boron or gallium.

Fig.2

Fig.1

Fig.3

Fig.4

Fig.5

Fig. 6 A

Fig. 6 B

Fig. 7